# EUROPEAN PATENT SPECIFICATION

(11) **EP 1 413 057 B1**
(45) Date of publication and mention of the grant of the patent: **07.06.2006**
(21) Application number: 01994653.2
(22) Date of filing: 09.11.2001
(51) Int. Cl.: H03M 1/44

(54) **SWITCHED CAPACITOR PIPELINE AD-CONVERTER**
A/ WANDLER NACH DEM FLIESSBANDVERFAHREN MIT GESCHALTETEN KAPAZITÄTEN
CONVERTISSEUR ANALOGIQUE NUMERIQUE A PIPELINE DE CONDENSATEUR COMMUTE

(30) Priority: 16.11.2000 EP 00204033
(43) Date of publication of application: 28.04.2004
(73) Proprietor: Koninklijke Philips Electronics N.V., 5621 BA Eindhoven (NL)
(72) Inventor: BOUDEWIJNS, Arnoldus, J., J., NL-5656 AA Eindhoven (NL)
(74) Representative: Duijvestijn, Adrianus Johannes
(86) International application number: PCT/EP2001/013105
(87) International publication number: WO 2002/041496

(56) References cited:
- US-A- 5 574 457
- SONG B-S,TOMPSETT M F,LAKSHMIKUMAR K R: "A 12-bit 1-MSamples/s Capacitor Error-Averaging pipelined A/D Converter" IEEE JOURNAL OF SOLID-STATE CIRCUITS, vol. 23, no. 6, December 1998 (1998-12), pages 1324-1333, XP002261540

## Description

The present invention relates to a switched capacitor pipeline AD-converter as defined by the preamble of claim 1.

Such a switched capacitor pipeline AD-converter is known from US patent no. 5,574,457.

AD conversion plays an important role in present day electronics. Because digital signal processing is easier to design and better to reproduce than analog signal processing it is the trend to place more of the signal processing into the digital domain. This requires AD-converters with higher conversion rates and higher resolution in combination with preferably low power consumption and which can be implemented in low cost standard CMOS technology. It appears that pipeline AD-convertors are good candidates to fulfill these requirements.

The cells of the above described prior art pipeline AD-convertor may be realized with one comparison level halfway the maximum range of the analog input signal. The comparison then determines whether the signal level is in the upper half or in the lower half of its range. If the signal is in the upper half, the comparator generates a "one"-bit and the signals is shifted downwardly by one half of the maximum range. On the other hand, if the signal is in the lower half of its range, a "zero" bit is generated and the signal remains unshifted. Subsequently the signal is multiplied by a factor 2 for application to the next cell. The bits, generated by the cascade of cells, together constitute a digital word, the most significant bit of which is generated by the first cell and the least significant bit by the last cell. This digital word constitutes the digital representation of the analog input signal.

However, in this way, a high resolution AD-converter cannot be achieved because the accuracy of the comparison-level of the first cell should be higher then the accuracy represented by the least significant bit generated by the last cell of the cascade. With other words: when a 10-bit word has to be generated, the accuracy of the comparison of the first cell should be better than 1/1024. To avoid this inconvenience, each cell of the pipeline AD-converter may have two comparator levels e.g. at 3/8 and 5/8 of the maximum signal level. Each of the two comparators generates a bit which is "zero" when the analog signal is below the comparison level and which is "one" when the analog signal is above the comparison level. The bits derived from the lower-level comparators of the cells together constitute a digital word and the bits from the higher-level comparators of the cells together constitute another digital word. When the two words are completed, they are added together to make the digital word that constitutes the end-result of the AD-converter. In this case, when the input signal level is close to the mid-level of the range and consequently falls in the mid-range between 3/8 and 5/8 of the maximum level, the decision as to the value of the most significant bit is delayed. Only when the results of the following cells is available and the two digital words are added, the value of the most significant bit is finally determined. The same holds for the determination of the other bits. The effect of this measure is that the value of the comparator levels is much less critical then in the case of a converter with only one comparator level.

On the other hand, in each pipeline cell the analogue signal has to be multiplied by a factor 2 to provide the input signal for the next pipeline cell and this factor has to be very accurate in case a high resolution AD-converter is required. In prior art switched capacitor pipeline AD-converters this factor is strongly dependent on the value of the capacitors in the multiplication- and shift-means. It is the primary object of the present invention to substantially improve the accuracy of the multiplication factor and therefore the switched capacitor pipeline AD-converter of the present invention is characterized in that the first and second capacitors are, during an output mode, switched to preserve their respective charges and to add their voltages for generating the analog signal for the next cell.

In most prior art circuits the first and second capacitors are, during the output mode, both connected to the inverting input terminal of an operational amplifier, i.e. one is connected between the inverting input and the output of the operational amplifier and the other between the inverting input and a reference potential. The multiplication by the factor 2 is then obtained in that during the output mode the electric charge from the second capacitor is transferred to the first capacitor where it is added to the original charge of this first capacitor. In this way the multiplication by the factor 2 is obtained if the two capacitors are exactly equal. However, in standard CMOS technology it is difficult to make the two capacitors sufficiently equal to each other.

The essentiality of the invention is that the charge, which is loaded into the capacitors during the input mode, is kept in their respective capacitor during the output mode and that the multiplication by 2 is obtained by adding the voltages of the two capacitors. This implies that the capacitors may have different values without affecting the multiplication factor. The parasitic capacitances, especially those at the input of the amplifier, cause unequal first and second capacitors to have still some influence on the value of the multiplication factor, but this influence is far lower than in the prior art case where the charge of one capacitor is transferred to the other capacitor to realize the factor 2 multiplication. Other advantages of the AD-converter of the present invention are:
- Usually the required shift level is added to one of the first and second switched capacitors. The measure of the invention has the result that also the shift level is much less dependent from the value of these capacitors.
- Any charge transfer implies energy dissipation which is higher the higher the operating frequency is. By avoiding the transfer of charge during the output mode the required power is substantially reduced.
- Any charge transfer needs time. By avoiding the charge transfer during the output mode the AD-converter operates faster, so that higher operating frequencies are possible.

The multiplication without substantial charge transfer between the two capacitors can be obtained by connecting the capacitors in series during the output mode. However, the parasitic capacitances then still take some of the charge from the capacitors, so that the desired multiplication factor of 2 cannot be reached. A simple and reliable arrangement to overcome this drawback is obtained when, according to a further aspect of the invention, during the output mode the first capacitor is switched between an output and an inverting input of a differential amplifier and the second capacitor is switched between a non-inverting input of the differential amplifier and a reference voltage. With this arrangement it is achieved that the detrimental effect of the parasitic capacitance at one input terminal of the differential amplifier is counteracted by the parasitic capacitance at the other input terminal of the differential amplifier.

A preferred pipeline AD-converter in accordance with the invention is further characterized in that during the input mode the first capacitor of the multiplication- and shift-means receives one of the partial signals of a differential input signal and the second capacitor of the multiplication- and shift-means receives the other of the partial signals. With a differential input signal the parasitic capacitances at the inputs of the differential amplifier are usually more equal to each other, so that an improved counteraction of their detrimental effects is obtained. Another advantage is that the shift level need to be available during the output mode, so that the comparison of the input signal with the predetermined comparison level(s) can be achieved during the input mode.

When a pipeline cell has a differential signal input, such cell should also have a differential output in order to be able to be connected to the next cell with differential input. However, it is not possible to use a symmetrical arrangement with one single differential amplifier with two fed back differential outputs, because both input terminals of the amplifier are already used for the generation of one single ended output signal. Therefore, the pipeline AD-converter of the present invention may be further characterized in that a differential output is obtained by two identical multiplication- and shift-means which receive the differential input signal in counter-phase and which additionally receive a shift level which is switched in counter-phase.

In order to increase the speed and consequently to increase the sample rate and/or the resolution of the AD-converter, the switched capacitor pipeline AD-converter according to the invention may still further be characterized in that the multiplication and switch means comprise two equally circuited sets of switched capacitors, one of said sets of switched capacitors having in- and output-terminals which are interconnected with the corresponding in- and output- terminals of the other of said sets of switched capacitors and in that said sets are switched so that one set operates in the input mode when the other operates in the output mode and vice versa.

The invention will be further explained with reference to the attached figures. Herein shows:
Figure 1 a schematic diagram of one cell of a pipeline AD-converter,
Figure 2 a schematic diagram of a prior art multiplication- and shift-unit for use in a pipeline AD-converter,
Figure 3 a schematic diagram of a multiplication- and shift-unit for use in a pipeline AD-converter according to the invention,
Figure 4 a schematic diagram of a multiplication - and shift-unit.
Figure 5 a schematic diagram of one cell of a pipeline AD-converter according to the invention and
Figure 6 a schematic diagram of a modified multiplication- and shift-unit for use in the AD-converter-cell of figure 5.

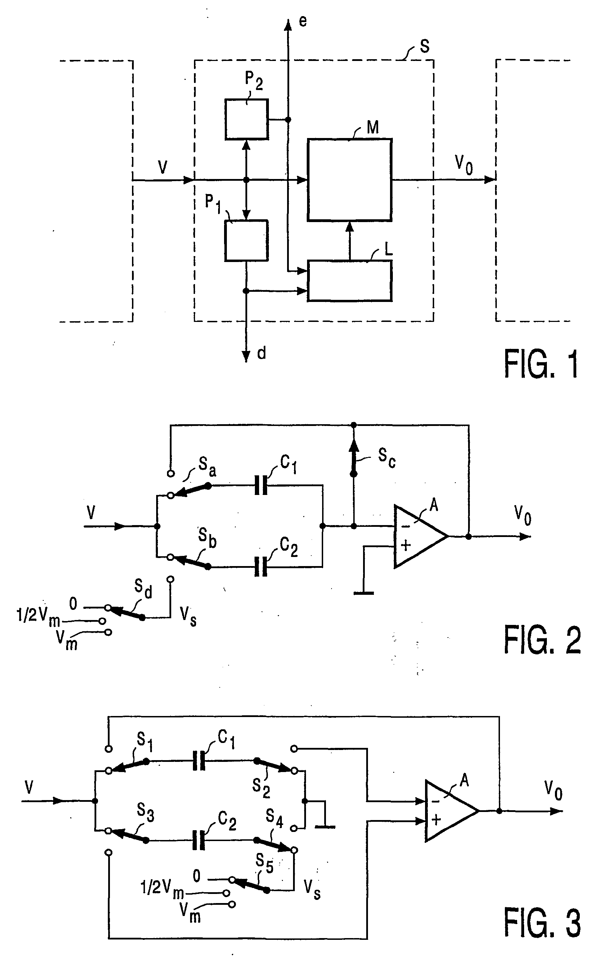

In figure 1 a cell S of a pipeline AD-converter comprises an input terminal I to which an analog input signal V is applied which is generated by the previous cell of the converter. The signal V is applied to two comparators P₁ and P₂. The comparator P₁ compares the signal V with a comparison level which is e.g. 3/8 of the maximum range of the signal (3/8 Vₘ). Similarly, the comparator P₂ compares the signal V with a comparison level which is e.g. 5/8 of this maximum range (5/8 Vₘ). The comparator P₁ generates a bit d which is "zero" when V < 3/8 Vₘ and which is "one" when V > 3/8 Vₘ; equally the comparator P₂ generates a bit e which is "zero" when V < 5/8 Vₘ and which is "one" when V > 5/8 Vₘ. The signal V is also applied to a multiplication- and shift-unit M. This unit delivers the analog output signal Vₒ of the cell S which serves as input signal for the next cell in the cascade. The d- and e-bits additionally control a logic unit L which in turn controls the shift operation of the multiplication- and shift-unit M. The overall result is as follows:
- When the level of the input signal V is below 3/8 Vₘ, the bits d and e are both "zero" and the signal V is amplified with the factor 2 in the unit M. No shift of the signal takes place.
- When the level of the input signal V is between 3/8 Vₘ and 5/8 Vₘ, the bit d is "one" and the bit e is "zero". The signal V is amplified with the factor 2 and the amplified signal is shifted downwardly by one half of the maximum range Vₘ.
- When the level of the input signal V is above 5/8 Vₘ, the bits d and e are both "one". The signal V is again amplified with the factor 2 and the amplified signal is shifted downwardly by the full value of the maximum range Vₘ.

The same procedure is carried out in the other cells of the cascade, in each next cell one clock period later than in its predecessor. The bits d of all cells are collected and delayed in register means (not shown). The bit d of a particular cell in the cascade is delayed one clock period more than the bit d of the next cell in the cascade, so that all the bits d of one sample are simultaneously available to constitute one digital word. The same holds for the bits e, so that finally one digital word comprising all the bits d and one digital word comprising all the bits e are simultaneously present. The two digital words are then added to constitute the output of the AD-converter.

Figure 2 shows an example of a prior art implementation of the multiplication- and shift-unit in the arrangement of figure 1. The unit comprises first and second capacitors C₁ and C₂ respectively and an operational amplifier A. Two bipolar switches Sₐ and S_{b}, and a unipolar switch S_{c} are switched synchronously between an input mode and an output mode; in figure 2 they are drawn in the position which they have during the input mode. A tripolar switch S_{d} is controlled by the logic L (of figure 1) for delivering the required shift level Vₛ, either 0 or ½Vₘ or Vₘ as is already explained with reference to figure 1. In this figure 2, for easy understanding, the switches Sₐ, S_{b} and S_{c} are shown as bipolar or tripolar switches, however in practical implementations the bipolar switch Sₐ is preferably formed by two unipolar switches and the tripolar switch S_{d} and the bipolar switch S_{b} by four unipolar switches.

Switch Sₐ connects one terminal of the capacitor C₁ to the input signal V during the input mode and to the output of the amplifier A during the output mode. Switch S_{b} connects one terminal of capacitor C₂ to the input signal V during the input mode and to the switch S_{d} during the output mode. The other terminals of capacitors C₁ and C₂ are both connected to the inverting input (-) of the operational amplifier. The switch S_{c} connects during the input mode the output of the operational amplifier to its inverting input. The non-inverting input (+) of this amplifier is connected to ground.

In operation, during the input mode, the operational amplifier is fed back through the closed switch S_{c}, so that the inverting input (-) assumes substantially the same potential (ground) as the non inverting input (+). Moreover, through the switches Sₐ and S_{b}, both capacitors C₁ and C₂ are loaded with the input signal V. During the output mode the logic L brings the switch S_{d} in the position to deliver the required shift level Vₛ and the position of each of the switches Sₐ to S_{c} is changed, so that the capacitor C₁ is now connected between the output and the inverting input of the operational amplifier and the capacitor C₂ is connected between the shift level Vₛ and the inverting input of the operational amplifier. This implies that a current flows from the output of the operational amplifier, through capacitor C₁ and through capacitor C₂ to the Vₛ source. This current flow results in a charge transfer between the two capacitors so that the voltage of the inverting input of the operational amplifier equals the voltage (ground) of the non-inverting input. When the capacitances of these capacitors are equal (= C), the charge transfer ΔQ = (V - Vₛ).C and the output voltage of the operational amplifier Vₒ = 2.V - Vₛ, so that both the required amplification by the factor 2 and the required voltage shift is realized. However, when the capacitors C₁ and C₂ are unequal the charge transfer ΔQ = (V - Vₛ).C₂ and the output signal Vₒ = V.(1+C₂/C₁) - Vₛ.C₂/C₁. Both the amplification factor and the voltage shift are incorrect and dependent on the values of the capacitors.

It may be noticed that, in practice, the arrangement of figure 2 may be extended for differential signals when the operational amplifier has a differential output and the rest of the circuit is mirrored, whereby the (+) input terminal of the amplifier serves as the inverting input for the differential counterpart of the signal Vₒ.

The multiplication- and shift-unit of figure 3 reduces the dependency of the multiplication factor from the capacitors C₁ and C₂. In this figure corresponding elements with those of figure 2 have been given the same references. A switch S₁ connects one terminal of the capacitor C₁ to the input signal V during the input mode and to the output of the amplifier A during the output mode. A switch S₂ connects the other terminal of the capacitor C₁ to a reference potential (which is supposed to be zero in the calculation below) during the input mode and to the inverting input (-) of the amplifier A during the output mode. A switch S₃ connects one terminal of the capacitor C₂ to the input signal V during the input mode and to the non inverting input (+) of the amplifier A during the output mode. And a switch S₄ connects the other terminal of the capacitor C₂ to said reference potential during the input mode and to the shift level Vₛ during the output mode. Now, during the input mode, capacitor C₁ is, again, loaded with the input signal V and capacitor C₂ is loaded with the input signal V minus the shift level Vₛ; therefore the voltage across C₂ is V - Vₛ. During the output mode, the capacitor C₂ is connected between the non-inverting input of the operational amplifier A and ground, so that the voltage of said non-inverting input is V - Vₛ. Furthermore, the operational amplifier is fed back through capacitor C₁ whereby the inverting input (-) adopts the potential V - Vₛ of the non-inverting input (+) and the output voltage Vₒ of the operational amplifier is the voltage V of capacitor C₁ higher than the voltage V - Vₛ of the inverting input (-). Therefore, the output of the operational amplifier is Vₒ = 2.V - Vₛ. This result is irrespective of the capacitance values of C₁ and C₂, because there is no current flowing through these capacitors during the output mode and consequently there is no charge transfer between the two capacitors during this mode.

It may be observed that the voltages, mentioned above, are with reference to "ground" i.e. to the zero-potential of the shift-level Vₛ. In practice this ground potential will usually lay above the negative supply voltage of the circuit. Practical arrangements in standard CMOS-technology may have a "ground"-potential of 0,7 Volt above the negative supply potential and Vₘ = 1,4 Volt, so that the signal V may vary from 0,7 to 2,1 Volt above the negative supply potential. The same holds for the arrangements of the other figures.

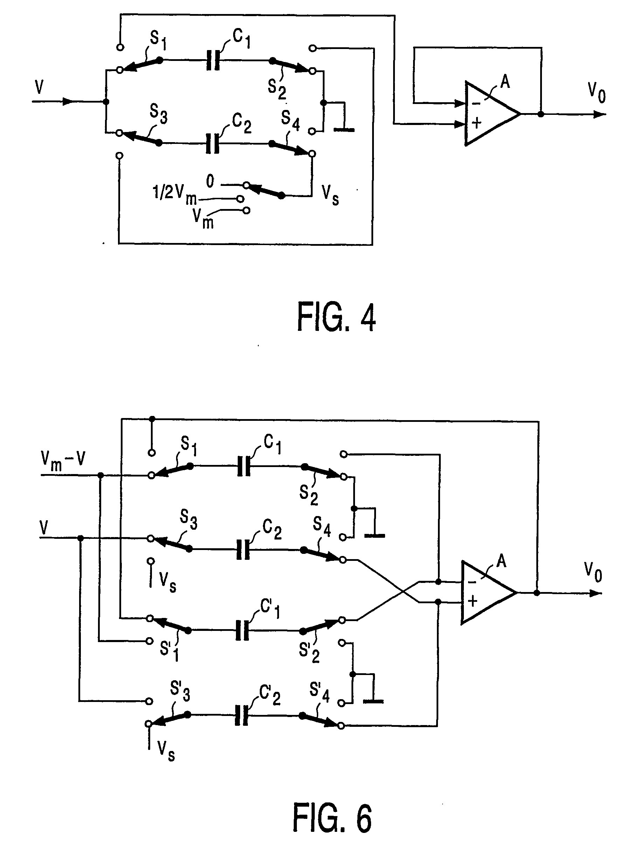

Theoretically it is also possible to avoid charge transfer between the two capacitors by simply connecting the two capacitors in series during the output mode. This is depicted in figure 4. The capacitors C₁ and C₂ are loaded during the input mode by V and V-Vₛ respectively and during the output mode they are connected in series thereby providing the output signal 2.V-Vₛ. The operational amplifier A is connected as impedance transformer in the output lead, in order to prevent large output current from flowing through the two capacitors. However, when the unavoidable parasitic capacitances are taken into account, it may be seen that, during the output mode, the parasitic capacitance of the interconnection between the capacitors C₁ and C₂ with respect to ground and the parasitic capacitance of the interconnection between the capacitor C₁ and the non-inverting amplifier input (+) with respect to ground give an attenuation of the output voltage, so that the required amplification factor 2 cannot be obtained. In the arrangement of figure 3 the parasitic capacitance of the non inverting input (+) of the amplifier towards ground gives an attenuation, but the parasitic capacitance of the inverting input (-) with respect to ground gives an amplification. And these two may, in the ideal case, balance out so that the optimum multiplication factor of 2 may be obtained.

A serious drawback of the embodiment of figure 3, however, is that the shift level Vₛ has to be available already during the input mode. Therefore, before the input mode in which the capacitors C₁ and C₂ are loaded, an extra mode has to be introduced in which the comparators P₁ and P₂ are active. Of course, such extra mode reduces the sampling rate of the AD-converter. Another drawback of the embodiment of figure 3 is that the parasitic capacitance at the interconnection between the capacitor C₂ and the switch S₃ gives an attenuation of the shift level Vₛ at the non inverting input (+) of the amplifier A.

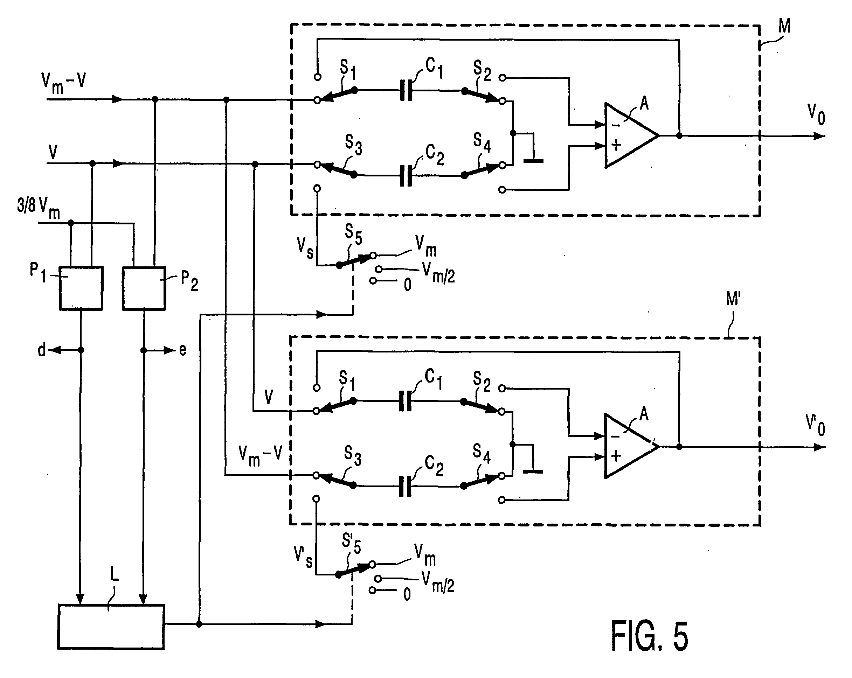

These drawbacks may be overcome in the embodiment of figure 5, which shows a pipeline cell with a differential signal input. The embodiment comprises two multiplication- and shift units M and M' respectively, in which corresponding elements with those of the previous figures again have the same reference numerals.

The arrangement receives a differential analog input signal consisting of two partial signals V and Vₘ - V. The signal V varies between 0 and Vₘ and the signal Vₘ - V consequently varies in counter-phase between Vₘ and 0. Most essential of this arrangement is that, during the input mode, one of the partial signals (Vₘ - V in unit M) is loaded into the capacitor C₁ and the other of the partial signals (V in unit M) is loaded into capacitor C₂. During the output mode, the switches S₁ and S₂ connect the capacitor C₁ between the inverting input and the output of the operational amplifier A and the switches S₃ and S₄ connect the capacitor C₂ between the shift level Vₛ and the non inverting input of the operational amplifier A of the unit M. Therefore, during the output mode, the non inverting input (+) of the operational amplifier receives the voltage Vₛ - V; the fed-back operational amplifier causes its inverting input (-) to adopt the same voltage Vₛ - V and this voltage plus the voltage Vₘ - V of capacitor C₁ constitutes the output voltage Vₒ = Vₛ - V + Vₘ - V = Vₛ + Vₘ - 2.V of the unit M.

Correspondingly in unit M', the signal V is loaded during the input mode into capacitor C₁ and the signal Vₘ - V is loaded during this mode into capacitor C₂. During the output mode the switches S₁ and S₂ again connect the capacitor C₁ between the inverting input (-) and the output of the amplifier A of this unit M' and the switches S₃ and S₄ connect the capacitor C₂ between, in this case, the shift level Vₛ' and the non inverting input (+) of the operational amplifier. Therefore, during the output mode, the non inverting input of the amplifier A receives the voltage Vₛ' minus the voltage Vₘ - V i.e. Vₛ' - Vₘ + V. The fed back amplifier causes its inverting input to adopt the same voltage Vₛ' - Vₘ + V and this voltage plus the voltage V of capacitor C₁ constitute the output Vₒ' = Vₛ' - Vₘ +2.V of the unit M'.

It may be noted that, while the shift level Vₛ for the unit M is derived by switch S₅, the shift level Vₛ' for the unit M' is derived by a switch S₅' which switches inversely to the switch S₅, so that the sum of the two switch levels Vₛ + Vₛ' = Vₘ. It can further be seen, that the two output Voltages Vₒ and Vₒ' vary in counter-phase between 0 and Vₘ and that their sum Vₒ + Vₒ' is also equal to Vₘ: (Vₛ + Vₘ - 2.V) + (Vₛ' - Vₘ + 2.V) = Vₛ + Vₛ' = Vₘ. Therefore the output signals Vₒ and Vₒ' are suitable to be applied to a next pipeline cell which is identical in architecture to the cell depicted in figure 5.

The embodiment of figure 5 shows the two comparators P₁ and P₂ and the logic unit L which controls the two switches S₅ and S₅'. The comparator P₁, like the corresponding comparator of figure 1, compares the analog input signal V with the comparator level of 3/8.Vₘ. The comparator P₂ compares the signal Vₘ - V with the level of 3/8.Vₘ, which is identical to comparing the voltage V with the level of 5/8.Vₘ of figure 1.

In each of the multiplication- and shift-units in the above figures the capacitors (C₁, C₂,) and their switches (S₁, S₂, S₃, S₄) may conveniently be doubled with the corresponding input and output terminals interconnected, but with the switches S₁ to S₄ operating in counter-phase so that one of the sets of capacitors operates in the input mode while the other operates in the output mode and vice versa. This is depicted for the unit M in figure 6 with the capacitors C₁' and C₂' and the switches S₁' to S₄' . In this way the speed of the AD-converter is doubled. Moreover it is avoided that the output voltages of the amplifiers become temporarily undefined.

The arrangement of figure 5 may be modified in that the switches S₂ and S₄ are deleted, the capacitor C₁ is continuously connected to the inverting input (-) of the amplifier A and this connection is switched during the input mode to the output of the amplifier (as in the prior art arrangement of figure 2) and that the capacitor C₂ is continuously connected to the non inverting input (+) of the amplifier and this connection is switched during the input mode to a reference voltage of e.g. ½Vₘ. In this modification the amplifier A for one partial output signal (Vₒ or Vₒ') during the input- and the output mode, so that the speed-doubling, as explained above with reference to figure 6, is not possible in this arrangement.

It has to be remarked, that the switching from input mode to output mode and vice versa should preferably not be done by all switches simultaneously. In order to avoid inappropriate connections, the switches which connect the input terminals of the operational amplifier (e.g. in figure 5 the switches S2 and S4) should open before the other switches. The subsequent closing of the switches is less critical and may be done simultaneously.

It is further remarked that the amplifier A in the arrangement according to the invention is preferably an operational transconductance amplifier (OTA) which transfers the voltage between the two input terminals into an output current.

## Claims

1. A switched capacitor pipeline AD-converter with a cascade of cells, each of said cells comprising:
- comparison means (P₁, P₂) to compare a received analog signal (V) with at least one predetermined comparison level and to output one or more digital bits representing the result of the comparison,
- multiplication and shift-means (M) to multiply the analog signal with a factor 2 and to shift the analog input signal with a shift level (Vₛ) which depends on the result of the comparison such as to produce a multiplied and shifted analog signal (Vₒ), and
- means to output the multiplied and shifted analog signal (Vₒ) for application to the next cell in the cascade of cells,
the multiplication- and shift-means (M) comprising first (C₁) and second (C₂) capacitors which are both switched to receive the analog signal during an input mode, whereby the first (C₁) and second (C₂) capacitors are, during an output mode, switched to preserve their respective charges and to add their voltages for generating the analog signal (Vₒ) for the next cell, **characterized in that** during the output mode the first capacitor (C₁) is switched between an output and an inverting input of an operational amplifier (A) and that the second capacitor (C₂) is switched between a non-inverting input of the operational amplifier and a reference voltage.

2. A switched capacitor pipeline AD-converter as claimed in claim 1 wherein each of the cells receive a differential input signal consisting of two partial signals (V, Vₘ₋V), **characterized in that** during the input mode the first capacitor (C₁) of the multiplication- and shift-means (M) receives one of the partial signals of the differential input signal and the second capacitor (C₂) of the multiplication- and shift-means receives the other of the partial signals.

3. A switched capacitor pipeline AD-converter as claimed in claim 2 **characterized by** two identical multiplication- and shift-means (M, M') which receive the differential input signal (V/Vₘ-V, Vₘ-V/V) in counter-phase and which additionally receive a shift level (Vₛ, Vₛ') which is switched in counter-phase.

4. A switched capacitor pipeline AD-converter as claimed in any of the preceding claims, **characterized in that** the multiplication and switch means comprise two equally circuited sets of switched capacitors, one of said sets (C₁, C₂, S₁, S₂, S₃, S₄) of switched capacitors having in- and output-terminals which are interconnected with the corresponding in- and output-terminals of the other of said sets (C₁', C₂', Sᵢ', S₂', S₃', S₄') of switched capacitors and **in that** said sets are switched so that one set operates in the input mode when the other operates in the output mode and vice versa.

## Patentansprüche

1. Pipeline-A/D-Wandler mit geschalteten Kapazitäten mit einer Kaskade von Zellen, wobei jede Zelle Folgendes umfasst:
- Vergleichsmittel (P₁, P₂), um ein empfangenes analoges Signal (V) mit mindestens einem vorher festgelegten Vergleichspegel zu vergleichen und ein oder mehrere digitale Bits, die das Ergebnis des Vergleichs repräsentieren, auszugeben;
- Multiplikations- und Verschiebemittel (M), um das analoge Signal mit einem Faktor 2 zu multiplizieren und das analoge Signal um einen Verschiebepegel (Vₛ), der von dem Ergebnis des Vergleichs abhängt, zu verschieben, um ein multipliziertes und verschobenes analoges Signal (Vₒ) zu erzeugen,
- Mittel, um das multiplizierte und verschobene analoge Signal (Vₒ) zur Verwendung in die nächste Zelle in der Kaskade von Zellen auszugeben,
wobei die Multiplikations- und Verschiebemittel (M) erste (C₁) und zweite (C₂) Kapazitäten umfassen, die beide geschaltet werden, um während eines Eingangsmodus das analoge Signal zu empfangen, wobei die erste (C₁) und die zweite (C₂) Kapazität während eines Ausgabemodus geschaltet werden, um ihre jeweiligen Ladungen zu bewahren und um ihre Spannungen zu addieren, um das analoge Signal (Vₒ) für die nächste Zelle zu erzeugen, **dadurch gekennzeichnet, dass** während des Ausgabemodus die erste Kapazität (C₁) zwischen einen Ausgang und einen invertierenden Eingang eines Operationsverstärkers (A) geschaltet wird und die zweite Kapazität (C₂) zwischen einen nicht invertierenden Eingang des Operationsverstärkers und einer Referenzspannung geschaltet wird.

2. Pipeline-A/D-Wandler mit geschalteten Kapazitäten nach Anspruch 1, in dem jede der Zellen ein differenzielles Eingangssignal empfängt, das aus zwei Teilsignalen (V, Vₘ-V) besteht, **dadurch gekennzeichnet, dass** während des Eingangsmodus die erste Kapazität (C₁) der Multiplikations- und Verschiebemittel (M) eines der Teilsignale des differenziellen Eingangssignals empfängt und die zweite Kapazität (C₂) der Multiplikations- und Verschiebemittel das andere der Teilsignale empfängt.

3. Pipeline-A/D-Wandler mit geschalteten Kapazitäten nach Anspruch 2, **gekennzeichnet durch** zwei identische Multiplikations- und Verschiebemittel (M, M'), die das differenzielle Eingangssignal (VNₘ-V, Vₘ-V/V) im Gegentakt empfangen und die zusätzlich einen Verschiebepegel (Vₛ, Vₛ') empfangen, der im Gegentakt geschaltet wird.

4. Pipeline-A/D-Wandler mit geschalteten Kapazitäten nach einem der vorhergehenden Ansprüche, **dadurch gekennzeichnet, dass** die Multiplikations- und Schaltmittel zwei gleich beschaltete Sätze von geschalteten Kapazitäten umfassen, einer der genannten Sätze von geschalteten Kapazitäten (C₁, C₂, S₁, S₂, S₃, S₄) Ein- und Ausgangsanschlüsse hat, die mit den entsprechenden Ein- und Ausgangsanschlüssen des anderen der genannten Sätze von geschalteten Kapazitäten (C₁', C₂', S₁', S₂', S₃', S₄') verbunden sind, und **dadurch**, dass die genannten Sätze so geschaltet werden, dass ein Satz im Eingangsmodus arbeitet, wenn der andere im Ausgabemodus arbeitet und umgekehrt.

## Revendications

1. Convertisseur A/N en pipeline à condensateurs commutés avec une cascade de cellules, chacune desdites cellules comprenant :
- des moyens de comparaison (P₁, P₂) pour comparer un signal analogique reçu (V) à au moins un niveau de comparaison prédéterminé et pour fournir en sortie un ou plusieurs bits numériques représentant le résultat de la comparaison,
- des moyens de multiplication et de décalage (M) pour multiplier le signal analogique par un facteur 2 et pour décaler le signal d'entrée analogique d'un niveau de décalage (Vₛ) qui dépend du résultat de la comparaison de façon à produire un signal analogique multiplié et décalé (Vₒ), et
- des moyens pour délivrer en sortie le signal analogique multiplié et décalé (Vₒ) afin de l'appliquer à la cellule suivante de la cascade de cellules,
les moyens de multiplication et de décalage (M) comprenant des premier (C₁) et second (C₂) condensateurs qui sont tous deux commutés pour recevoir le signal analogique pendant un mode d'entrée, d'où il résulte que les premier (C₁) et second (C₂) condensateurs sont commutés pendant un mode de sortie de façon à conserver leurs charges respectives et à additionner leurs tensions pour produire le signal analogique (Vₒ) destiné à la cellule suivante, **caractérisé en ce que**, pendant le mode de sortie, le premier condensateur (C₁) est commuté entre une sortie et une entrée inverseuse d'un amplificateur opérationnel (A) et **en ce que** le second condensateur (C₂) est commuté entre une entrée non inverseuse de l'amplificateur opérationnel et une tension de référence.

2. Convertisseur A/N en pipeline à condensateurs commutés selon la revendication 1, **caractérisé en ce que** chacune des cellules reçoit un signal d'entrée différentiel constitué de deux signaux partiels (V, Vₘ - V), **caractérisé en ce que** pendant le mode d'entrée, le premier condensateur (C₁) des moyens de multiplication et de décalage (M) reçoit l'un des signaux partiels du signal d'entrée différentiel et **en ce que** le second condensateur (C₂) des moyens de multiplication et de décalage reçoit l'autre des signaux partiels.

3. Convertisseur A/N en pipeline à condensateurs commutés selon la revendication 2, **caractérisé par** deux moyens de multiplication et de décalage (M, M') identiques qui reçoivent le signal différentiel d'entrée (V/Vₘ - V, Vₘ - V/V) en opposition de phase et qui reçoit en outre un niveau de décalage (Vₛ, Vₛ') qui est commuté en opposition de phase.

4. Convertisseur A/N en pipeline à condensateurs commutés selon l'une quelconque des revendications précédentes, **caractérisé en ce que** les moyens de multiplication et de commutation comprennent deux ensembles de circuits équivalents constitués de condensateurs commutés, l'un desdits ensembles (C₁, C₂, S₁, S₂, S₃, S₄) de condensateurs commutés ayant des bornes d'entrée et de sortie qui sont interconnectées à des bornes d'entrée et de sortie correspondantes de l'autre desdits ensembles (C₁', C₂', S₁', S₂', S₃', S₄') de condensateurs commutés et **en ce que** lesdits ensembles sont commutés de façon à ce qu'un ensemble fonctionne dans le mode d'entrée lorsque l'autre fonctionne dans le mode de sortie, et inversement.
